# EUROPEAN PATENT APPLICATION

(11) **EP 4 333 418 A1**
(43) Date of publication of application: **06.03.2024**
(21) Application number: 22796165.3
(22) Date of filing: 28.04.2022
(51) Int. Cl.: H04N 5/225, G03B 17/55, H05K 1/02

(54) **CAMERA MODULE**

(30) Priority: 28.04.2021 KR 20210055039
(71) Applicant: Power Logics Co., Ltd, Chungcheongbuk-do 28121 (KR)
(72) Inventor: GU, Mean-Seok, Seongnam-si Gyeonggi-do 13486 (KR); LEE, Hee-Joong, Seongnam-si Gyeonggi-do 13486 (KR); KIM, Kyung-Jung, Seongnam-si Gyeonggi-do 13486 (KR); KIM, Jong-Ryul, Seongnam-si Gyeonggi-do 13486 (KR); KIM, Ki-Kang, Seongnam-si Gyeonggi-do 13486 (KR)
(74) Representative: Zacco Sweden AB
(86) International application number: PCT/KR2022/006070
(87) International publication number: WO 2022/231333

(57) **Abstract**

One embodiment of a camera module may comprise: a lens barrel; a heater arranged at the rear of the lens barrel; a connection unit, which has the heater mounted therein, is coupled to the lens barrel so as to be in close contact with the heater and is electrically connected to the heater; and a printed circuit board, which is accommodated in the connection unit, is electrically connected to the heater through the connection unit and has an image sensor mounted therein.

## Description

### [Technical Field]

The present invention relates to a camera module, and more specifically, to a camera module in which a heating device is provided.

### [Background Art]

Contents described in this section simply provide background information on the present invention and do not constitute the related art.

Camera modules for collecting image data are used in more and more application fields. For example, many camera modules are used in recent vehicles to accurately detect a surrounding environment of a vehicle and an interior space of the vehicle in some cases.

As the camera module used is further improved, an image quality can be further improved, and in some cases, additional functions may be integrated into the camera module. In addition, a miniaturization trend of the camera module used is also increasing.

Cameras mounted outside a vehicle may be greatly affected by an external environment. For example, on a snowy or rainy day, moisture including water droplets may be formed on a lens portion of the camera module. In addition, frost may be formed on the lens portion of the camera module in sub-zero weather.

When moisture or frost is formed on the lens portion of the camera module, resolutions of images captured by the camera module are significantly degraded, and when an image with a low resolution is used for a vehicle to travel, it is difficult to drive the vehicle, thereby causing an accident.

For example, a heating device may be provided in a camera module to remove the moisture and frost formed on the camera module. Such a heating device may be provided as a heater for generating heat in an electrical resistance manner.

In this regard, Korean Patent Application Laid-Open No. 10-2018-0085279 discloses a camera module having a structure including a heating element for heating an outermost lens.

Meanwhile, in order to supply a current to the heater for generating heat in the electrical resistance manner, a printed circuit board and the heater provided in the camera module may be electrically connected. It is common to use wires to connect the printed circuit board to the heater.

However, when the printed circuit board and the heater are connected by the wires, long time and efforts are required for assembling the camera module. In addition, the camera module may not operate or a malfunction thereof may occur due to connection failures of the wires.

Such a problem needs to be solved.

### [Technical Problem]

Therefore, the present invention is directed to providing a camera module having a structure in which a heater for generating heat in an electrical resistance manner and a printed circuit board are electrically connected without using a separate wire.

In addition, the present invention is directed to providing a camera module having a structure in which an amount of heat generated by an electrical resistance heater may be easily controlled.

Objects of the present invention are not limited to the above-described objects, and other objects and advantages of the present invention that are not mentioned can be understood by the following description and more clearly understood by embodiments of the present invention. In addition, it will be able to be easily seen that the objects and advantages of the present invention may be achieved by devices and combinations thereof that are described in the claims.

### [Technical Solution]

One embodiment of a camera module includes a lens barrel, a heater disposed at the rear of the lens barrel, a connection unit on which the heater is mounted and which is coupled to the lens barrel to be in close contact with the heater and electrically connected to the heater, and a printed circuit board which is accommodated in the connection unit and electrically connected to the heater through the connection unit, and on which an image sensor is mounted.

The connection unit may further include a conductive wire pattern that is in contact with the heater to be electrically connected to the heater and provided in the connection unit, and a temperature detection sensor electrically connected to the conductive wire pattern.

The connection unit may further include a switch electrically connected to the conductive wire pattern and configured to allow a current to be blocked or flow in the heater and the printed circuit board.

The printed circuit board may include a first connection pin mounted on a surface thereof facing the conductive wire pattern and in contact with the conductive wire pattern to electrically connect the connection unit to the printed circuit board.

The connection unit may include a spacer of which one surface is in close contact with the heater to be electrically connected to the heater and which includes the conductive wire pattern, the temperature detection sensor, and the switch, and a front case in which the heater and the spacer are accommodated and which is coupled to the lens so that the heater and the spacer are in close contact with each other.

The temperature detection sensor and the switch may be provided to be mounted on a surface facing the front case of the spacer.

The spacer and the front case may be made of a material to be injection-molded, and the conductive wire pattern may be made of a material having durability.

A guide groove may be formed in a surface of the front case facing the spacer, and the spacer may be formed with a guide protrusion formed to protrude toward the guide groove from a surface facing the front case and inserted into the guide groove to suppress rotation of the spacer.

The front case may include a first hollow formed at a position corresponding to the image sensor, and at least one insertion hole formed at a position spaced apart from the first hollow, and the spacer may include a protruding portion formed to protrude from a surface facing the front case and inserted into the insertion hole.

The spacer may include a via hole formed to pass through the spacer and having the conductive wire pattern provided on at least a portion of a surface of an inner wall thereof, an elastic deformation portion formed to protrude in a circumferential direction or a diameter direction of the spacer and provided to be elastically deformed, and a contact protrusion formed to protrude from a surface of an end portion of the elastic deformation portion facing the heater and coming into contact with the heater.

The spacer may have the conductive wire pattern provided on an end of the contact protrusion, and the heater and the contact protrusion may be in contact with each other so that the conductive wire pattern is electrically connected to the heater.

The spacer may further include a pattern formation portion which is formed by removing a portion of an outer circumference thereof and on which a portion of the conductive wire pattern for connecting both side surfaces of the spacer is formed.

The conductive wire pattern may be provided on side surfaces of the pattern formation portion and the protruding portion, and an end surface of the protruding portion may be provided with a terminal pattern connected to the conductive wire pattern and in contact with the first connection pin to electrically connect the conductive wire pattern to the first connection pin.

The temperature detection sensor and the switch may be provided to be mounted on a surface facing the printed circuit board of the connection unit.

The connection unit may be made of a material to be injection-molded, and the conductive wire pattern may be made of a material having durability.

The connection unit may include a via hole formed to pass through the connection unit and having the conductive wire pattern provided on at least a portion of a surface of an inner wall thereof, and a contact protrusion formed to protrude from a surface facing the heater and coming into contact with the heater.

The connection unit may have the conductive wire pattern provided on an end of the contact protrusion, and the heater and the contact protrusion may be in contact with each other so that the conductive wire pattern is electrically connected to the heater.

The connection unit may be provided with a terminal pattern provided on a surface facing the printed circuit board, connected to the conductive wire pattern, and in contact with the first connection pin to electrically connect the conductive wire pattern to the first connection pin.

The printed circuit board may include a first board accommodated in the connection unit, electrically connected to the heater through the connection unit, and having a second hollow formed in a portion corresponding to the image sensor, and a second board which is electrically connected to the first board and on which the image sensor is formed.

The first board may include a first connection pin provided on a surface facing the connection unit, and the second board may include a second connection pin provided on a surface facing the first board and electrically connecting the first board to the second board.

Another embodiment of a camera module includes a lens barrel, a heater disposed at the rear of the lens barrel, a connection unit on which the heater is mounted and which is coupled to the lens barrel to be in close contact with the heater and electrically connected to the heater, a rear case coupled to the rear of the connection unit, a conductive wire pattern that is in contact with the heater to be electrically connected to the heater and provided in the connection unit, a temperature detection sensor electrically connected to the conductive wire pattern, and a connector which is coupled to the rear case and on which an end portion of a cable is mounted.

The connection unit may include a spacer of which one surface is in close contact with the heater to be electrically connected to the heater and which includes a switch electrically connected to the conductive wire pattern, the temperature detection sensor, and a switch electrically connected to the conductive wire pattern, and a front case in which the heater and the spacer are accommodated and which is coupled to the lens so that the heater and the spacer are in close contact with each other, wherein a guide groove is formed in a surface of the front case facing the spacer, and the spacer is formed with a guide protrusion formed to protrude toward the guide groove from a surface facing the front case and inserted into the guide groove to suppress rotation of the spacer.

The connection unit may include a via hole formed to pass through the connection unit and having the conductive wire pattern provided in at least a portion of a surface of an inner wall thereof, a contact protrusion formed to protrude from a surface facing the heater and coming into contact with the heater, and a terminal pattern provided on a surface opposite to the surface facing the heater and connected to the conductive wire pattern.

### [Advantageous Effects]

In a camera module according to the present invention, a heater can be electrically connected to a printed circuit board by a conductive wire pattern provided in a connection unit and a connection pin provided on the printed circuit board. With this structure, the camera module does not include a separate wire for electrically connecting the heater to the printed circuit board.

Therefore, it is possible to facilitate the assembly work of the camera module, and since there is no concern about damage to a wire, it is possible to improve the durability of the camera module. In addition, it is possible to significantly reduce the time and efforts required for assembling the camera module and prevent the occurrence of a connection failure of the wire.

In addition, in the camera module according to the present invention, a switch for controlling an operation of a temperature detection sensor and the heater can be provided, and a controller provided on the printed circuit board can control the operation of the heater by a method of stopping a current being supplied to the heater by operating the switch when a temperature detected from the temperature detection sensor exceeds a set range.

Therefore, it is possible to easily control an amount of heat generated by the heater provided in the camera module.

Specific effects together with the above-described effects are described together with a description of the following detailed matters for carrying out the invention.

### [Description of Drawings]

FIG 1 is a perspective view of a camera module according to one embodiment.
FIG 2 is an exploded view illustrating the camera module according to one embodiment.
FIG 3 is a perspective view illustrating some components of the camera module according to one embodiment.
FIG 4 is a view illustrating the camera module of FIG 3 from which a lens barrel is omitted.
FIG 5 is an exploded view illustrating some components of the camera module according to one embodiment.
FIG 6 is a front view illustrating a spacer according to one embodiment.
FIG 7 is a rear view illustrating the spacer according to one embodiment.
FIG 8 is a perspective view illustrating a state in which the spacer and a heater according to one embodiment are coupled.
FIG 9 is a view illustrating the state of FIG 8 from which the heater is omitted.
FIG 10 is a side view illustrating the spacer of FIG 9.
FIG 11 is a side view illustrating the spacer of FIG 9 viewed in another direction.
FIG 12 is a perspective view illustrating a front case according to one embodiment.
FIG 13 is a front view illustrating the front case of FIG 12.
FIG 14 is a rear view illustrating the front case of FIG 12.
FIG 15 is an exploded view illustrating a camera module according to another embodiment.
FIG 16 is a perspective view illustrating a state in which a connection unit and a heater according to one embodiment are coupled.
FIG 17 is a view illustrating the state of FIG 16 from which the heater is omitted.
FIG 18 is a front view illustrating the connection unit of FIG 17.
FIG 19 is a perspective view illustrating the rear of the connection unit according to one embodiment.
FIG 20 is a view for describing operation of the camera module according to one embodiment.
FIG 21 is a view for describing operation of the camera module according to another embodiment.
FIG 22 is an exploded view illustrating a camera module according to still another embodiment.
FIG 23 is an exploded view illustrating a camera module according to yet another embodiment.

### [Modes of the Invention]

The above-described objects, features, and advantages will be described below in detail with reference to the accompanying drawings, and thus those skilled in the art to which the present invention pertains will be able to easily carry out the technical spirit of the present invention. In describing the present invention, when it is determined that a detailed description of the known technology related to the present invention may unnecessarily obscure the gist of the present invention, a detailed description thereof will be omitted. Hereinafter, exemplary embodiments according to the present invention will be described in detail with reference to the accompanying drawings. In the drawings, the same reference numerals are used to denote the same or similar components.

Although the terms "first," "second," and the like are used to describe various components, it goes without saying that these components are not limited by these terms. These terms are only used to distinguish one component from another component, and unless otherwise stated, it goes without saying that the first component may be the second component.

Throughout the specification, unless otherwise stated, each component may be singular or plural.

The singular expression used herein includes the plural expression unless the context clearly dictates otherwise. In the application, terms such as "composed of' or "comprising" should not be construed as necessarily including all of the various components or operations described in the specification and should be construed as not including some of the components or some of the operations or further including additional components or operations.

Throughout the specification, when "A and/or B" is described, this means A, B, or A and B unless otherwise specified, and when "C to D" is described, this means C or more and D or less unless otherwise specified.

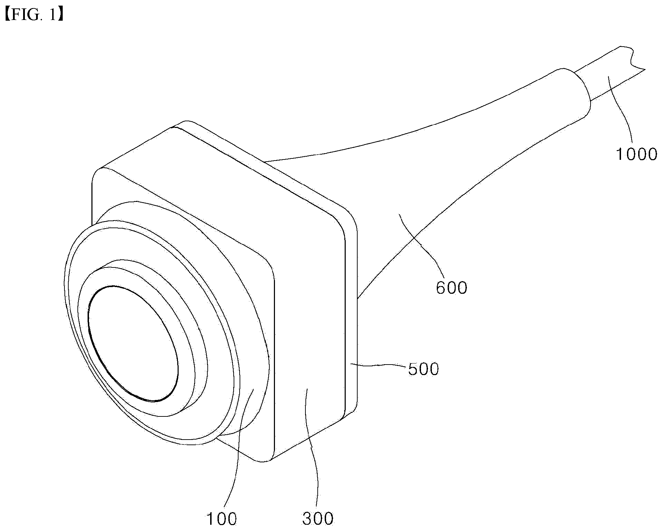

FIG 1 is a perspective view of a camera module according to one embodiment. The camera module according to the embodiment may be provided in a vehicle.

For example, the camera module may be used as a digital side mirror (DSM) camera. In other words, the camera module may replace a side mirror of the vehicle and provide a rearward image to a user of the vehicle. In addition, the camera module may be mounted on the rear of the vehicle and used as a rear camera for capturing images behind the vehicle.

In addition, the camera module may be mounted outside the vehicle and used to implement a surround view monitoring (SVM) system. Images captured by the camera module may be displayed on a display device provided in the vehicle.

In addition, the camera module may be used to implement an advanced driver assistance system (ADAS) used for autonomous driving of vehicles.

### [First embodiment]

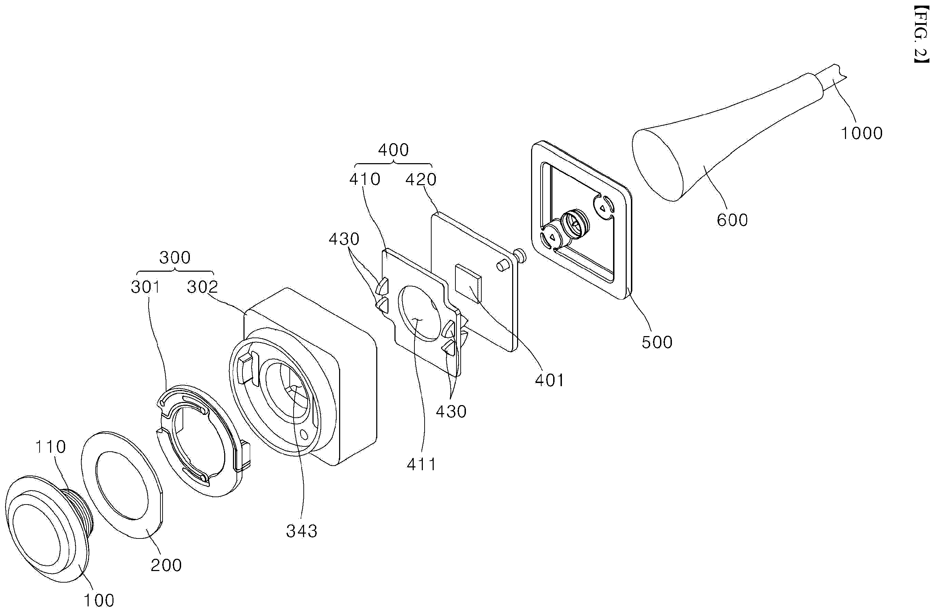

Hereinafter, a structure of the camera module according to a first embodiment will be described in detail with reference to FIGS. 2 to 14. FIG 2 is an exploded view illustrating the camera module according to one embodiment.

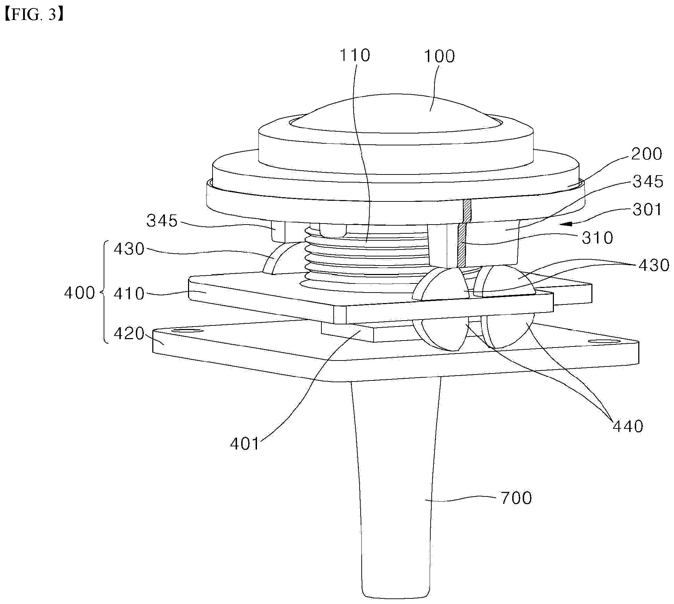

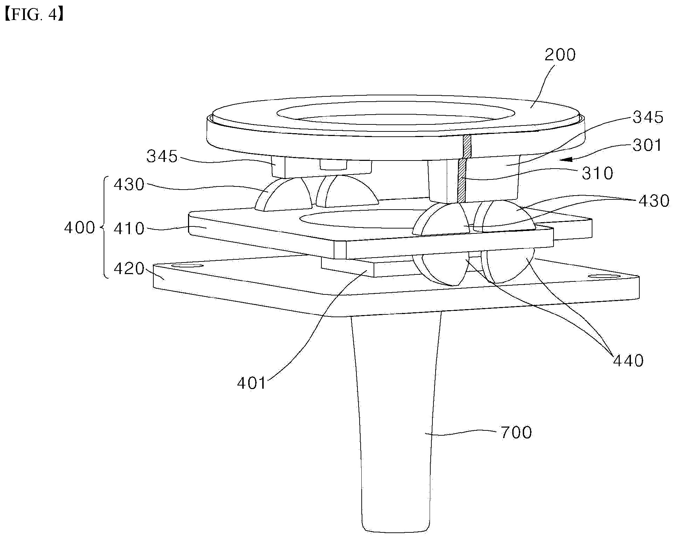

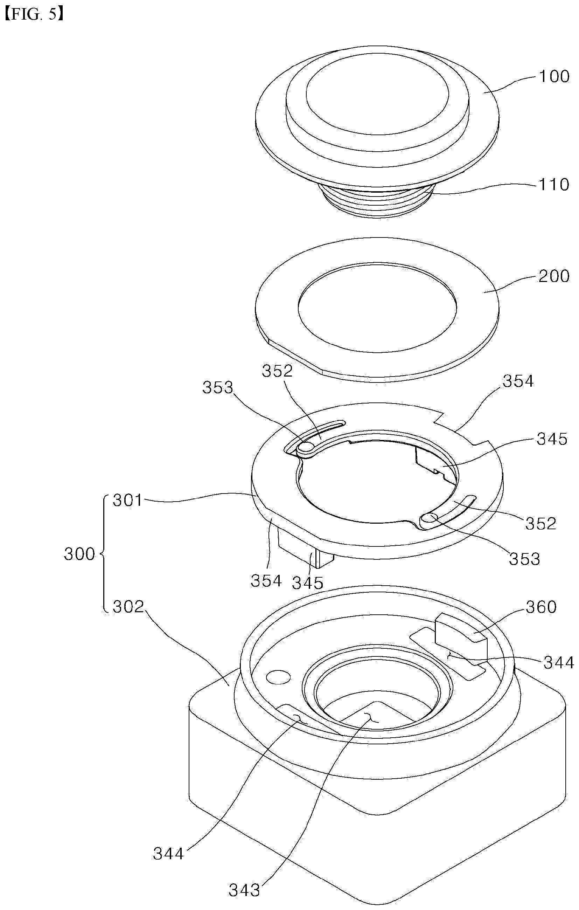

FIG 3 is a perspective view illustrating some components of the camera module according to one embodiment. FIG 4 is a view illustrating the camera module of FIG 3 from which a lens barrel 100 is omitted. FIG 5 is an exploded view illustrating some components of the camera module according to one embodiment. The camera module according to the embodiment may include the lens barrel 100, a heater 200, a connection unit 300, a printed circuit board 400, a rear case 500, and a connector 600.

The lens barrel 100 may be disposed at the forefront of the camera module. A portion of the lens barrel 100 in a longitudinal direction may be disposed to face an image sensor 401 mounted on the printed circuit board 400. The lens barrel 100 may include a lens array in which a plurality of lenses are arranged, wherein the lens is at least one of a concave lens, a convex lens, and a flat lens.

The lens array may be formed so that the plurality of lenses are arranged in an optical axis direction, that is, in a direction in which the lens barrel 100 faces the image sensor 401. Meanwhile, a screw-coupling portion 110 that may be screw-coupled to the connection unit 300 may be formed at the rear of the lens barrel 100.

A screw thread having a structure corresponding to a screw of the screw-coupling portion 110 may be formed on the connection unit 300. Therefore, when the lens barrel 100 is screw-coupled to the connection unit 300, the heater 200 may be in close contact with the lens barrel 100.

In addition, when the lens barrel 100 is screw-coupled to the connection unit 300, the heater 200 is in close contact with the connection unit 300, and thus a conductive wire pattern 310 provided in the connection unit 300 may be in close contact with the heater 200, and the connection unit 300 and the heater 200 may be electrically connected.

The heater 200 may be disposed behind the lens barrel 100. Specifically, the heater 200 may be disposed on a stepped portion formed on a front end portion of the screw-coupling portion 110 of the lens barrel 100. When the lens barrel 100 and the connection unit 300 are screw-coupled, the heater 200 may be in close contact with the lens barrel 100, and heat from the heater 200 may be transferred to the lens barrel 100.

As illustrated in FIG 2, the entirety of the heater 200 may be provided in a ring shape in which a hollow is formed and provided in a plate shape. The lens barrel 100 may be inserted into the hollow of the heater 200.

The heater 200 may be heated to generate heat, and the generated heat may be transferred to the lens barrel 100 to heat the lens barrel 100. Therefore, moisture, frost, or the like generated on the lens barrel 100 may be removed by the heat.

The heater 200 may be provided as an electrical resistance heating device. Therefore, the heater 200 may include, for example, a resistance heating portion heated when a current flows and a frame in which the resistance heating unit is mounted and which forms an exterior of the heater 200. The resistance heating portion may include two terminals to be electrically connected to the conductive wire pattern 310 provided in the connection unit 300.

The heater 200 has high energy efficiency and is appropriately provided to be quickly heated to a high temperature. An example of a material that has high energy efficiency and is quickly heated to a high temperature is a carbon fiber. Therefore, the resistance heating portion, which is a heating portion of the heater 200, may be appropriately made of the carbon fiber.

In addition, the carbon fiber has excellent thermal durability. When the heater is made of a material other than the carbon fiber, which has low thermal durability, performance is degraded within a relatively short time due to heating when the heater is operated continuously and repeatedly.

In the embodiment, the heater 200 having the resistance heating portion made of the carbon fiber is used. Therefore, by using the heater 200 made of the carbon fiber that has excellent thermal durability compared to other materials, there is an advantage in that there is no or very little degradation in performance due to the heating of the heater 200 and the camera module even after long-term use.

The heater 200 is disposed behind the lens barrel 100 and thus does not block a forward field of view of the lens barrel 100. With this structure, the camera module according to the embodiment may function as a wide-angle camera by being equipped with a wide-angle lens.

The connection unit 300 may be equipped with the heater 200 and coupled to the lens barrel 100, and thus may be in close contact with the heater 200 and may be electrically connected to the heater 200. A hollow may be formed in the connection unit 300, and the screw thread corresponding to the screw-coupling portion 110 of the lens barrel 100 may be formed on a circumferential surface forming the hollow.

In the camera module according to the first embodiment, the screw thread corresponding to the screw-coupling portion 110 may be formed in both a spacer 301 and a front case 302 forming the connection unit 300. Alternatively, the screw thread is not formed in the spacer 301, and the screw thread may be formed in only the front case 302.

The connection unit 300 may include the conductive wire patterns 310, temperature detection sensors 320, and a switch 330. The conductive wire pattern 310 may be electrically connected to the heater 200 by being in contact with the heater 200 and provided in the connection unit 300. In this case, the conductive wire pattern 310 may be provided, for example, by a method of being printed on the connection unit 300, but the present invention is not limited thereto.

The conductive wire pattern 310 may function as a conductive wire allowing a current to flow by being provided on a surface of the connection unit 300. The entirety of the conductive wire pattern 310 may have a three-dimensional shape by being provided on the surface of the three-dimensional connection unit 300.

The temperature detection sensor 320 may be electrically connected to the conductive wire pattern 310. The temperature detection sensor 320 may detect a temperature of the connection unit 300 because it is disposed inside the connection unit 300. When the temperature detected by the temperature detection sensor 320 exceeds a set range, a controller provided on the printed circuit board 400 may control an amount of heat generated by the heater 200 in order to suppress overheating of the connection unit 300.

In one embodiment, the controller may control the amount of heat generated by the heater 200 by controlling an amount of current applied to the heater 200. When the detected temperature exceeds the set range, the controller may decrease the amount of heat generated by the heater 200 by decreasing the amount of current applied to the heater 200. In the case of such a current amount control method, the switch 330 to be described below may not be provided.

In another embodiment, the switch 330 may be provided in the connection unit 300, and the controller may control the amount of heat generated by the heater 200 by operating or stopping the operation of the heater 200 using the switch 330.

The switch 330 may be electrically connected to the conductive wire pattern 310 and may allow a current to be blocked or flow in the heater 200 and the printed circuit board 400. A current may or may not flow to the heater 200 by the switch 330 operated by a command of the controller.

The current flowing to the heater 200 may be supplied through the printed circuit board 400. Therefore, when the detected temperature exceeds the set range, the controller may block the current between the heater 200 and the printed circuit board 400 by operating the switch 330 and decrease the temperature of the connection unit 300 by stopping the operation of the heater 200.

When the temperature of the connection unit 300 is in the set range because the operation of the heater 200 is stopped, the controller allows the current to flow between the heater 200 and the printed circuit board 400 by re-operating the switch 330, and thus the heater 200 may re-generate heat.

The printed circuit board 400 may be accommodated in the connection unit 300, electrically connected to the heater 200 through the connection unit 300, and equipped with the image sensor 401. The printed circuit board 400 may be provided with a conductive wire on a surface thereof and provided with various active elements and passive elements required for the operation of the camera module.

The printed circuit board 400 may be electrically connected to an external power source, and the heater 200 may be electrically connected to an external power source through the printed circuit board 400. Therefore, since the printed circuit board 400 for controlling the overall operation of the camera module and the heater 200 are electrically connected to the same external power source, it is possible to implement the power source sharing for the camera module and the heater 200 provided therein.

In addition, the controller may be provided on the printed circuit board 400, and the controller may detect the temperature of the connection unit 300 through the temperature detection sensor 320 and control the amount of current applied to the heater 200 or operate the switch 330 to start or stop the operation of the heater 200.

For electrical connection with the connection unit 300, the printed circuit board 400 may include first connection pins 430 disposed at positions at which the conductive wire pattern 310 and the printed circuit board 400 face each other. The first connection pins 430 may be mounted on a surface of the printed circuit board 400 facing the conductive wire pattern 310 and may come into contact with the conductive wire pattern 310 to electrically connect the connection unit 300 to the printed circuit board 400.

The printed circuit board 400 may be coupled to the connection unit 300 by a coupler 2000 such as a bolt. In this case, an end of the first connection pin 430 may come into contact with the conductive wire pattern 310 provided in the connection unit 300, and thus the conductive wire pattern 310 may be electrically connected to the printed circuit board 400.

The lens barrel 100 and the connection unit 300 may be screw-coupled to electrically connect the heater 200 to the connection unit 300, and the printed circuit board 400 may be coupled to the connection unit 300 by the coupler 2000 to electrically connect the connection unit 300 to the printed circuit board 400. Therefore, the heater 200, the connection unit 300, and the printed circuit board 400 may be electrically connected.

The connection pins provided as the first connection pins 430 and second connection pins 440 to be described below may be made of a conductive material such as a metal and may have a structure capable of elastic deformation. Therefore, the first connection pin 430 may be slightly deformed while in close contact with the conductive wire pattern 310 of the connection unit 300.

The first connection pin and the second connection pin may be provided as, for example, pogo pins, but the present invention is not limited thereto.

Referring to FIG 2, the printed circuit board 400 according to the embodiment may be separately provided as a first board 410 and a second board 420. In the camera module, the first board 410 may be disposed in front of the second board 420. The first board 410 and the second board 420 may be coupled to the connection unit 300 or the front case 302 by the coupler 2000.

The first board 410 may be accommodated in the connection unit 300 and electrically connected to the heater 200 through the connection unit 300, and a second hollow 411 may be formed on a portion corresponding to the image sensor 401. The second board 420 may be accommodated in the connection unit 300, electrically connected to the first board 410, and equipped with the image sensor 401.

The first board 410 may be equipped with elements, such as a capacitor for supplying electricity to the spacer 301 in the first embodiment and the connection unit 300 in a second embodiment and provided with a circuit for connecting these elements.

The second board 420 may be equipped with the image sensor 401 for capturing images outside the camera module, provided with the controller for controlling the camera module, a communication device for communication with an electronic control unit (ECU) 20, or the like, and provided with a circuit for connecting these elements.

The first board 410 may include the first connection pins 430 provided on the surface facing the connection unit 300. A structure of the first connection pin 430 is the same as described above.

The second board 420 may include the second connection pins 440. The second connection pin 440 may be provided on a surface of the second board 420 facing the first board 410 and may be in contact with a terminal of the first board 410 to electrically connect the first board 410 to the second board 420.

The second connection pin 440 may be made of a conductive material such as a metal and may have a structure capable of elastic deformation. Therefore, the second connection pin 440 may be slightly deformed while in close contact with a terminal of a first pattern. The connection unit 300, the first board 410, and the second board 420 may be electrically connected by the first connection pins 430 and the second connection pins 440.

The rear case 500 may be coupled to the rear of the connection unit 300 to form a space in which the printed circuit board 400 is accommodated. Meanwhile, in the first embodiment, the rear case 500 may be coupled to the rear of the front case 302.

The camera module may have a terminal 700 coupled to the printed circuit board 400 to connect an external cable 1000 to the printed circuit board 400. Therefore, a passage through which the terminal 700 and the cable 1000 may pass may be formed in the rear case 500.

The rear case 500 and the connection unit 300 may be coupled, for example, by fusing using a laser. In another embodiment, the rear case 500 and the connection unit 300 may be detachably coupled by a bolt, etc.

The connector 600 may be equipped with an end portion of the cable 1000 connecting the camera module to an external power source, the ECU 20, and other electrical devices. The connector 600 may be coupled to the rear case 500, and the cable 1000 may be electrically connected to the terminal 700 coupled to the printed circuit board 400 through the passage connected to the rear case 500 and the connector 600.

The connection unit 300 according to the first embodiment may include the spacer 301 and the front case 302, which are separate components. The spacer 301 may be mounted on the front case 302, and the front case 302 may be coupled to the rear case 500 to form a space in which the first board 410 and the second board 420 are disposed. In this case, the terminal 700 for connection with the external cable 1000 may be coupled to the second board 420.

The spacer 301 may be mounted in front of the front case 302, and the heater 200 may be mounted in front of the spacer 301. When the lens barrel 100 is coupled to the front case 302, the heater 200 and the spacer 301 may be in close contact with each other, and thus the heater 200 and the spacer 301 may be electrically connected.

Referring to FIG 5, in order for the heater 200 to be mounted in front of the spacer 301, a recess for mounting the heater 200 may be formed in the front of the spacer 301. In order for the spacer 301 to be mounted in front of the front case 302, a recess for mounting the spacer 301 may be formed in the front of the front case 302.

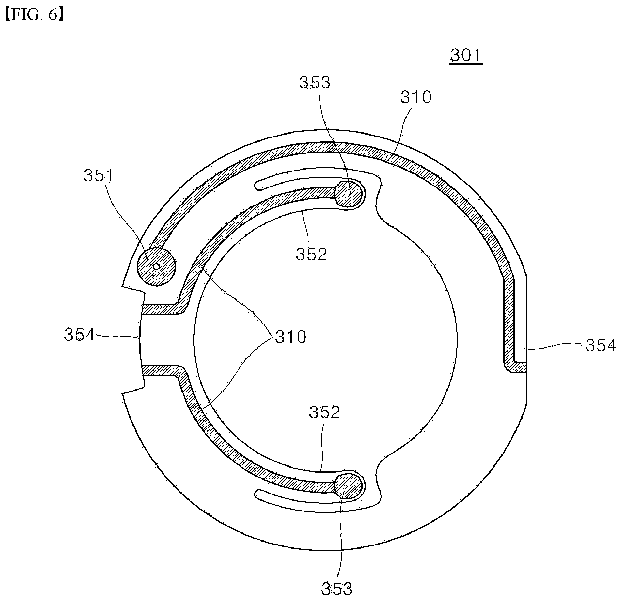

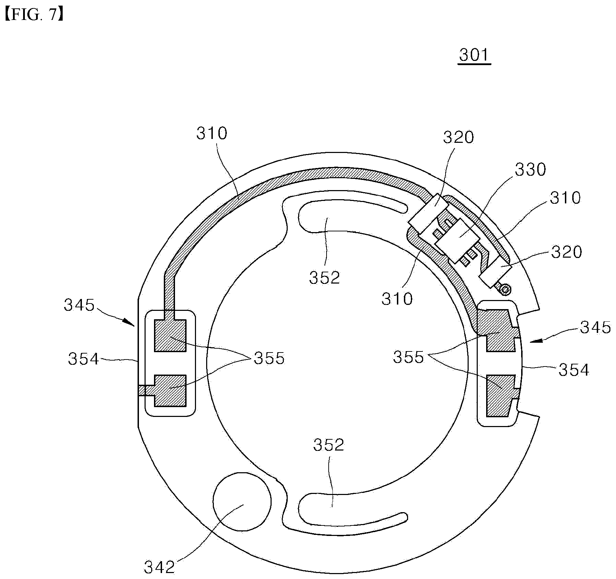

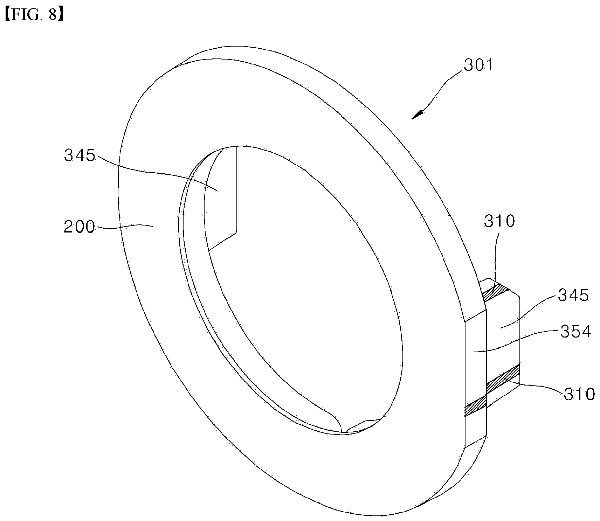

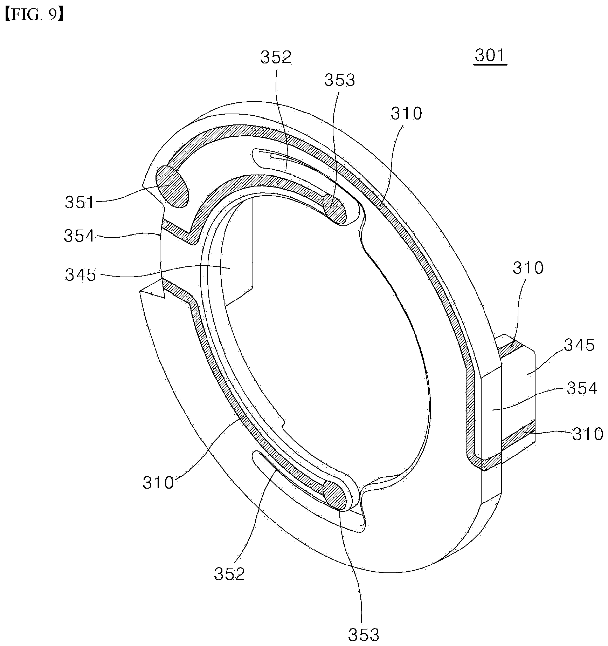

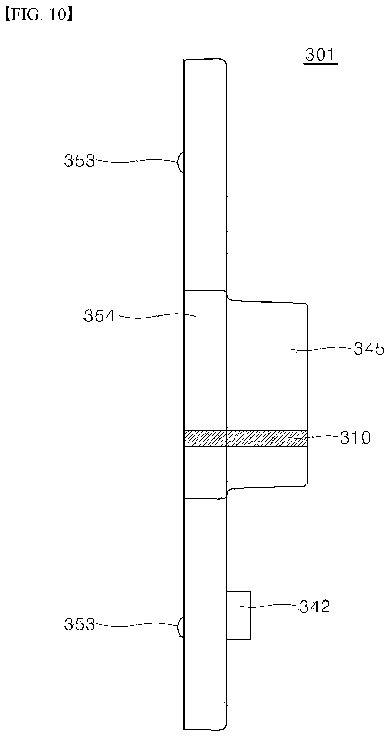

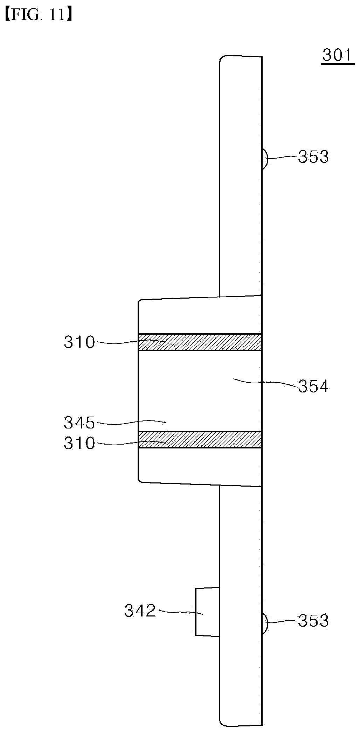

FIG 6 is a front view illustrating the spacer 301 according to one embodiment. FIG 7 is a rear view illustrating the spacer 301 according to one embodiment. FIG 8 is a perspective view illustrating a state in which the spacer 301 and the heater 200 according to one embodiment are coupled. FIG 9 is a view illustrating the state of FIG 8 from which the heater 200 is omitted. FIG 10 is a side view illustrating the spacer 301 of FIG 9. FIG 11 is a side view illustrating the spacer 301 of FIG 9 viewed in another direction.

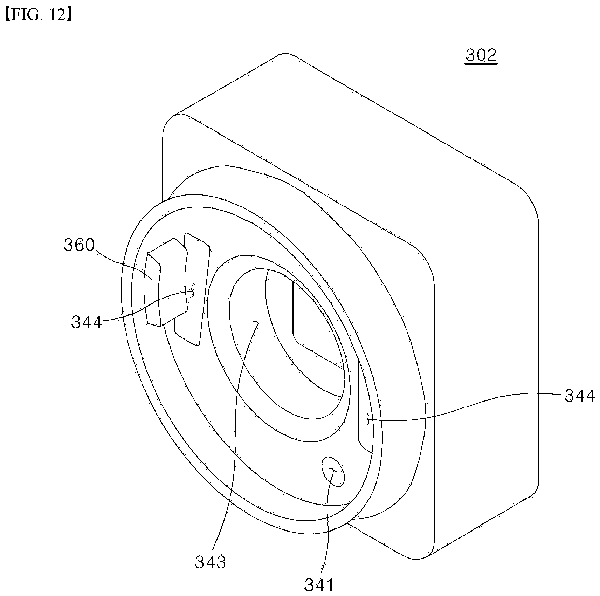

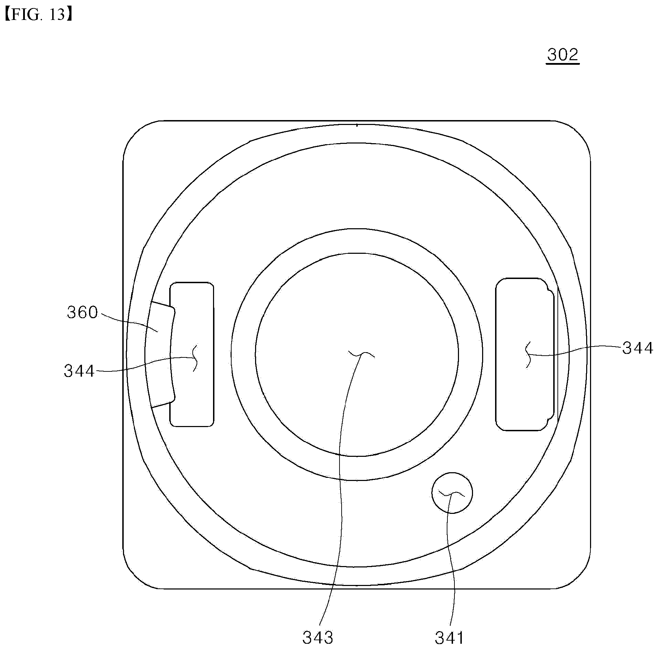

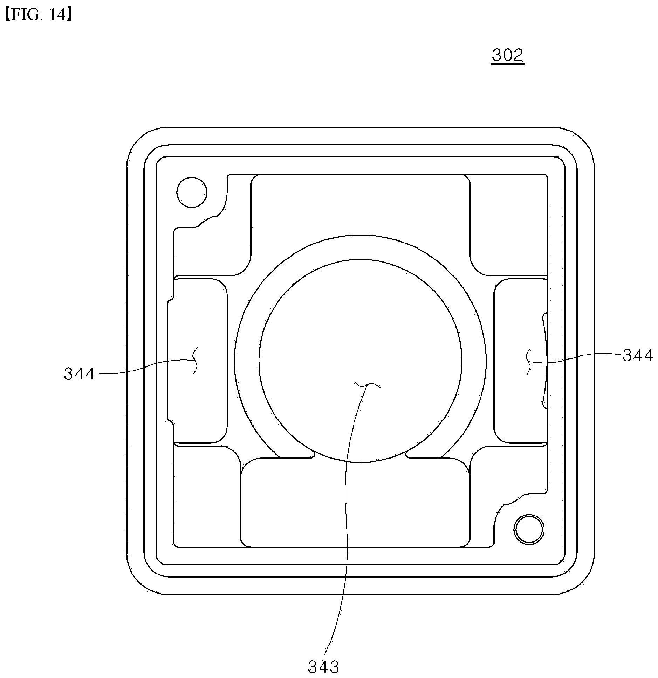

FIG 12 is a perspective view illustrating the front case 302 according to one embodiment. FIG 13 is a front view illustrating the front case 302 of FIG 12. FIG 14 is a rear view illustrating the front case 302 of FIG 12.

As illustrated in FIG 7, the temperature detection sensor 320 and the switch 330 may be provided in the spacer 301, and a plurality of temperature detection sensors 320 may be provided. Since the temperature detection sensor 320 and the switch 330 may each be, for example, formed of a thin plate-shaped element and mounted on the spacer 301, it is possible to effectively reduce a space in which the temperature detection sensor 320 and the switch 330 occupy.

The temperature detection sensor 320 and the switch 330 may be provided to be mounted on a surface of the spacer 301 facing the front case 302, that is, at the rear of the spacer 301.

The conductive wire pattern 310 for electrically connecting the heater 200 to the first board 410 may be provided on the surface of the spacer 301. The conductive wire pattern 310 may be formed on the front and rear of the spacer 301 and formed in an appropriate shape for the operation and control of the heater 200 and the switch 330.

Since the heater 200 is disposed in close contact with the spacer 301, the heat generated from the heater 200 may be easily transferred to the spacer 301 and the front case 302 on which the spacer 301 is mounted. In this case, the spacer 301 and the front case 302 may each be appropriately made of a material having a relatively low thermal conductivity.

Since at least portions of the spacer 301 and the front case 302 are exposed to the outside, when the thermal conductivities of the spacer 301 and the front case 302 are high, an amount of heat emitted into the air through the spacer 301 and the front case 302 may increase. Therefore, the heat generated by the heater 200 may not heat the lens barrel 100, a large amount of heat may be emitted into the air, and excessive electricity may be consumed to heat the lens barrel 100.

In addition, when the thermal conductivities of the spacer 301 and the front case 302 are high, an excessive amount of heat may be transferred to the first board 410 and the second board 420 accommodated in the front case 302, resulting in a failure or degradation in the performance of the camera module.

In addition, since the spacer 301 and the front case 302 are provided in a three-dimensional shape with a complicated structure, the spacer 301 and the front case 302 may each be appropriately made of a material, which is easily injection-molded, for easy manufacturing.

Therefore, the spacer 301 and the front case 302 may each be made of a plastic material, which has a relatively low thermal conductivity and is easily injection-molded.

The conductive wire pattern 310 may be appropriately made of a material having excellent conductivity, durability, etching resistance, and chemical resistance, and thus may be made of, for example, a gold (Au) material.

A guide groove 341 may be formed in a surface of the front case 302 facing the spacer 301. Correspondingly, the spacer 301 may have a guide protrusion 342 formed to protrude toward the guide groove 341 from a surface facing the front case 302. The guide protrusion 342 may be inserted into the guide groove 341 to suppress the rotation of the spacer 301.

When the lens barrel 100 is rotated while inserted into the spacer 301 and the front case 302 for screw-coupling, the spacer 301 may rotate with respect to the front case 302, resulting in a failure of the assembly of the camera module.

Therefore, the guide protrusion 342 of the spacer 301 may be inserted into the guide groove 341 of the front case 302 to suppress the occurrence of a failure of the assembly of the camera module in which the spacer 301 rotates with respect to the front case 302 and thus is not disposed at a designed position when the camera module is assembled.

The spacer 301 may include protruding portions 345 passing through the front case 302, the conductive wire pattern 310 may be formed on a surface of the protruding portion 345, and the conductive wire pattern 310 may be electrically connected to the first board 410, and thus the spacer 301 and the first board 410 may be electrically connected.

The front case 302 may include a first hollow 343 formed at a position corresponding to the image sensor 401 and at least one insertion hole 344 formed at a position spaced apart from the first hollow 343. In the embodiment, a pair of insertion holes 344 may each be formed at one of positions spaced apart from each other in both side directions of the first hollow 343.

The spacer 301 may include the protruding portion 345 formed to protrude from the surface facing the front case 302 and inserted into the insertion hole 344. In the embodiment, a pair of protruding portions 345 may each be formed at one of positions spaced apart from each other to correspond to the pair of insertion holes 344.

The spacer 301 may include a via hole 351 and pattern formation portions 354 in order to electrically connect the conductive wire patterns 310 formed on a front surface facing the heater 200 and the rear surface facing the front case 302.

The via hole 351 may be formed to pass through the spacer 301, and the conductive wire pattern 310 may be provided on at least a portion of a surface of an inner wall thereof. In this case, the conductive wire pattern 310 formed on the surface of the inner wall of the via hole 351 may be connected to the conductive wire patterns 310 formed on the front surface and the rear surface of the spacer 301.

Since the via hole 351 has the conductive wire pattern 310 formed on the surface of the inner wall thereof, the conductive wire patterns 310 formed on the front surface and the rear surface of the spacer 301 may be electrically connected through the via hole 351.

For example, the via hole 351 may electrically connect the conductive wire pattern 310 formed on the front surface of the spacer 301 and the conductive wire patterns 310 which is formed on the rear surface of the spacer 301 and to which the temperature detection sensor 320 and the switch 330 are connected.

The pattern formation portion 354 may be formed by removing a portion of an outer circumference of the spacer 301, and a portion of the conductive wire patterns 310 for connecting both side surfaces of the spacer 301 is formed. Since the conductive wire pattern 310 is formed on a surface of the pattern formation portion 354, the conductive wire patterns 310 formed on the front surface and the rear surface of the spacer 301 may be electrically connected through the wire pattern 310 formed on the pattern formation portion 354.

In the embodiment, a pair of pattern formation portions 354 may each be formed at one of positions spaced apart from each other. In this case, the pair of pattern formation portions 354 may have different shapes. Since the shapes are different, when the spacer 301 is mounted on the front case 302 when the camera module is assembled, it is possible to suppress misassembly in which portions of the spacer 301 in left and right directions are mounted on the front case 302 differently from a design.

One of the pattern formation portions 354 may be formed in a recessed type having a shape in which the outer circumference of the spacer 301 is recessed to a certain depth, and the other one may be formed in a flat type that has a shape in which a portion of the outer circumference of the spacer 301 has a planar surface or a smoothly curved surface.

The front case 302 may include a stopper 360 having a shape corresponding to a portion corresponding to the recessed pattern formation portion 354 of the spacer 301. In this case, the recessed pattern formation portion 354 of the spacer 301 may function to suppress the rotation of the spacer 301 by being shape-fitted into the stopper 360 provided in the front case 302.

The stopper 360 together with the guide groove 341 may function to suppress the occurrence of the failure of the assembly of the camera module by suppressing the rotation of the spacer 301 with respect to the front case 302 when the camera module is assembled.

The conductive wire pattern 310 may be formed on each of the front surface and the rear surface of the spacer 301, and the conductive wire pattern 310 may also be formed on the surface of the inner wall of the via hole 351 passing through the spacer 301. Therefore, the entirety of the conductive wire pattern 310 may be formed on the spacer 301 having a three-dimensional shape to have a three-dimensional shape.

For electrical connection between the heater 200 and the spacer 301, the spacer 301 may include elastic deformation portions 352 and contact protrusions 353.

The elastic deformation portion 352 may be formed to protrude in a circumferential direction or a diameter direction of the spacer 301 and provided to be elastically deformed. The elastic deformation portion 352 may be provided by forming a recess in a portion of the spacer 301.

Referring to FIG 6, the elastic deformation portion 352 having a shape protruding in the circumferential direction of the spacer 301 may be formed by forming a recess in an inner circumferential surface of the spacer 301. Since the elastic deformation portion 352 is electrically connected to the heater 200 having two terminals, a pair of elastic deformation portions may also be provided to correspond to the two terminals of the heater 200.

When the contact protrusion 353 formed on the elastic deformation portion 352 comes into contact with the terminal of the heater 200, the elastic deformation portion 352 may be slightly elastically deformed by a pressing force of the heater 200.

The contact protrusion 353 may be formed to protrude from a surface of an end portion of the elastic deformation portion 352 facing the heater 200, that is, the front surface of the elastic deformation portion 352 and may come into contact with the heater 200. Like the elastic deformation portion 352, since the contact protrusion 353 is electrically connected to the heater 200 having two terminals, a pair of contact protrusions 353 may also be provided to correspond to the two terminals of the heater 200.

The spacer 301 may have the conductive wire pattern 310 provided at the end of the contact protrusion 353. When the lens barrel 100 is coupled to the spacer 301 and the front case 302, the heater 200 and the spacer 301 may be in close contact with each other. In this case, since the heater 200 and the contact protrusion 353 are in contact with each other, the conductive wire pattern 310 may be provided to be electrically connected to the heater 200.

For electrical connection between the spacer 301 and the first board 410, terminal patterns 355 may be provided on the spacer 301, and the first connection pin 430 may be provided on the first board 410.

The conductive wire pattern 310 may be provided on side surfaces of the pattern formation portion 354 and the protruding portion 345. Therefore, the conductive wire pattern 310 formed on the front surface of the spacer 301 may electrically connect the pattern formation portion 354 to the terminal pattern 355 formed on an end surface of the protruding portion 345 through the side surfaces of the protruding portion 345.

The end surface of the protruding portion 345 may be connected to the conductive wire pattern 310 and provided with the terminal pattern 355 in contact with the first connection pin 430 to electrically connect the conductive wire pattern 310 to the first connection pin 430. The terminal pattern 355 may be formed on the end surface of the protruding portion 345 to occupy a larger area than the other conductive wire patterns 310.

When the first board 410 is coupled to the front case 302 by the coupler 2000, the end of the first connection pin 430 may be in close contact with the terminal pattern 355, and thus the first board 410 may be electrically connected to the spacer 301.

In the embodiment, the heater 200 may be electrically connected to the printed circuit board 400 by the conductive wire patterns 310 provided in the connection unit 300 and the connection pins provided on the printed circuit board 400. With this structure, the camera module does not include a separate wire for electrically connecting the heater 200 to the printed circuit board 400.

Therefore, it is possible to facilitate the assembly work of the camera module, and since there is no concern about damage to a wire, it is possible to improve the durability of the camera module.

In the embodiment, the switch 330 for controlling the operation of the temperature detection sensor 320 and the heater 200 may be provided, and when the temperature detected from the temperature detection sensor 320 exceeds the set range, the controller provided on the printed circuit board 400 may control the operation of the heater 200 by a method of operating the switch 330 to stop a current being supplied to the heater 200.

Therefore, it is possible to easily control an amount of heat generated by the heater 200 provided in the camera module.

### [Second embodiment]

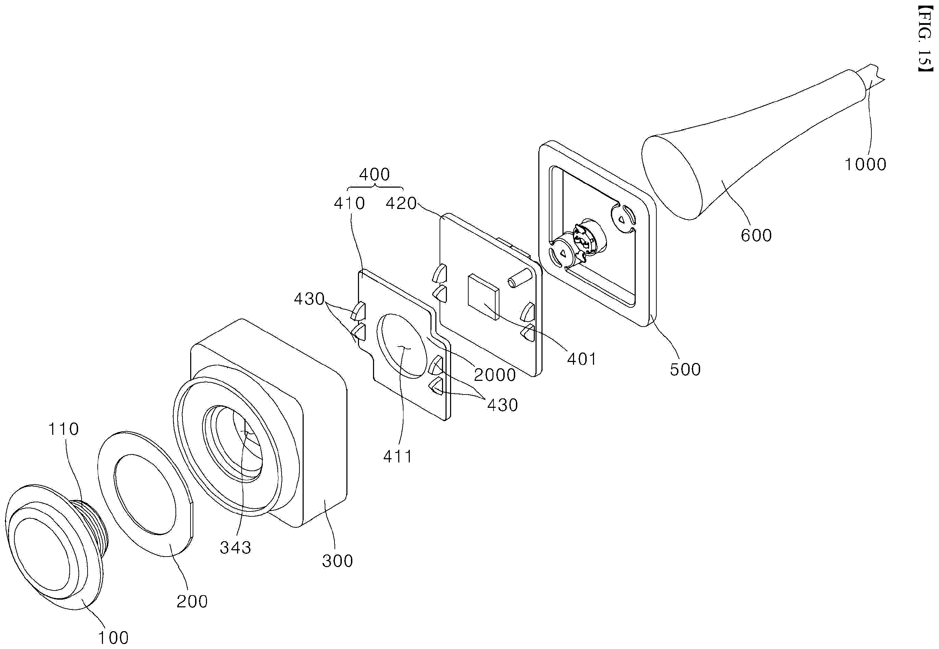

Hereinafter, a structure of a camera module according to a second embodiment will be described in detail with reference to FIGS. 15 to 19. In the following description, descriptions of parts overlapping the above description may be omitted.

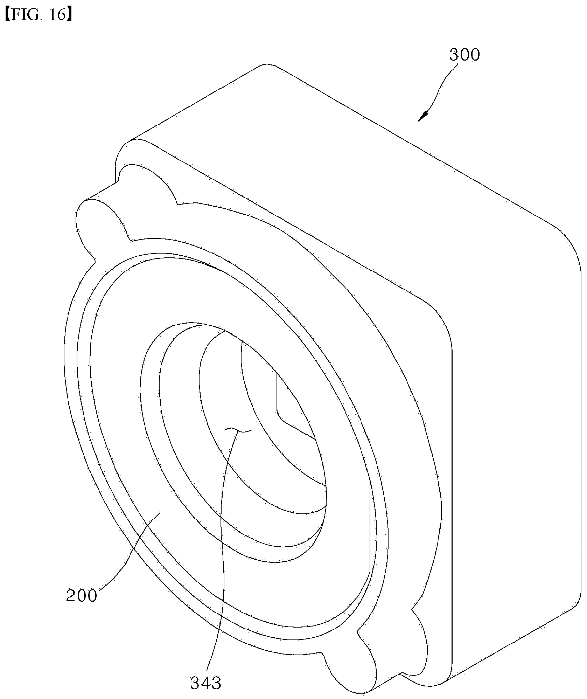

FIG 15 is an exploded view illustrating a camera module according to another embodiment. FIG 16 is a perspective view illustrating a state in which the connection unit 300 and the heater 200 according to one embodiment are coupled.

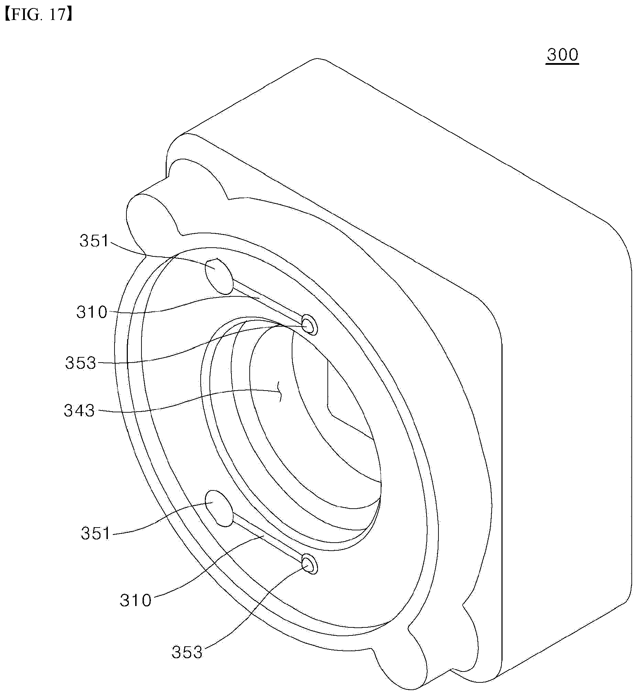

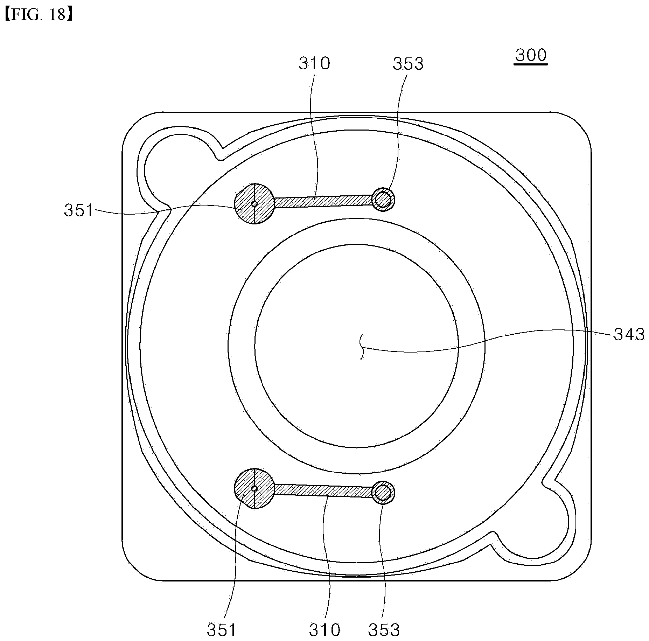

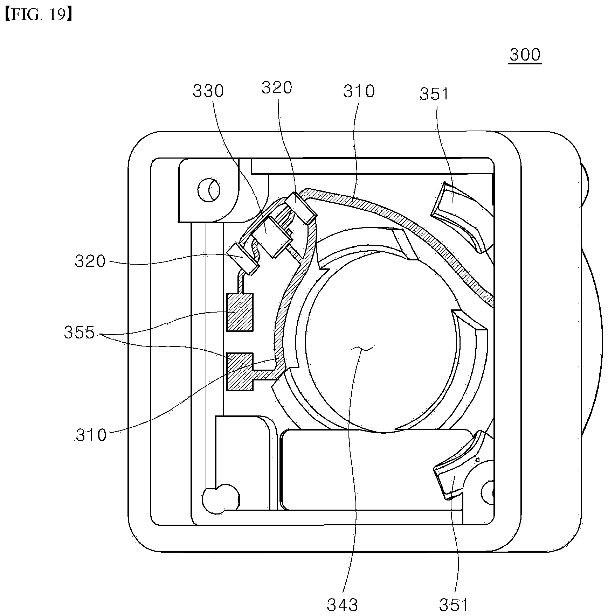

FIG 17 is a view illustrating the state of FIG 16 from which the heater 200 is omitted. FIG 18 is a front view illustrating the connection unit 300 of FIG 17. FIG 19 is a perspective view illustrating the rear of the connection unit 300 according to one embodiment.

The camera module according to the first embodiment includes the connection unit 300 having the spacer 301 and the front case 302 separated from each other and has a structure in which the temperature detection sensor 320, the switch 330, and the conductive wire pattern 310 are provided in the spacer 301.

In contrast, the camera module according to the second embodiment may include one integrated connection unit 300 in which the temperature detection sensor 320, the switch 330, and the conductive wire pattern 310 are formed. As in the first embodiment, the printed circuit board 400 may include the first board 410 and the second board 420 separated from each other.

In the camera module according to the second embodiment, the temperature detection sensor 320 and the switch 330 may be provided to be mounted on the surface of the connection unit 300 facing the printed circuit board 400, that is, the first board 410.

The connection unit 300 may be made of a material to be injection-molded, and the conductive wire pattern 310 may be made of a material having durability. As described above in the first embodiment, the connection unit 300 may be made of a plastic material that has a relatively low thermal conductivity and is easily injection-molded. In addition, the conductive wire pattern 310 may be made of a gold (Au) material having excellent conductivity, durability, etching resistance, and chemical resistance.

The conductive wire pattern 310 may be formed on the surface of the connection unit 300. The conductive wire patterns 310 may be formed on the front surface of the connection unit 300 facing the heater 200 and the rear surface of the connection unit 300 facing the first board 410, and the conductive wire patterns 310 may be connected by the conductive wire pattern 310 formed in the via hole 351.

The temperature detection sensor 320 and the switch 330 may be provided on the rear surface of the connection unit 300 to be electrically connected to the conductive wire pattern 310 formed on the rear surface of the connection unit 300. The temperature detection sensor 320 may detect the temperature of the connection unit 300.

The connection unit 300 may include the via hole 351 and the contact protrusion 353. The via hole 351 may be formed to pass through the connection unit 300, and the conductive wire pattern 310 may be provided on at least a portion of a surface of an inner wall of the via hole 351.

The contact protrusion 353 may be formed to protrude from the surface facing the heater 200 and may come into contact with the heater 200. For electrical connection with the heater 200 having two terminals, a pair of contact protrusions 353 may be provided.

The connection unit 300 may have the conductive wire pattern 310 provided at the end of the contact protrusion 353. When the lens barrel 100 is coupled to the connection unit 300, the heater 200 and the connection unit 300 may are in close contact with each other. In this case, since the heater 200 and the contact protrusion 353 are in contact with each other, the conductive wire pattern 310 may be provided to be electrically connected to the heater 200.

The terminal pattern 355 provided on the surface facing the printed circuit board 400 may be provided in the connection unit 300. The terminal pattern 355 may be formed on the rear surface of the connection unit 300 facing the first board 410. The terminal pattern 355 may be connected to the conductive wire pattern 310 and may be in contact with the first connection pin 430 to electrically connect the conductive wire pattern 310 to the first connection pin 430.

When the first board 410 is coupled to the connection unit 300 by the coupler 2000, the end of the first connection pin 430 may be in close contact with the terminal pattern 355, and thus the first board 410 may be electrically connected to the connection unit 300.

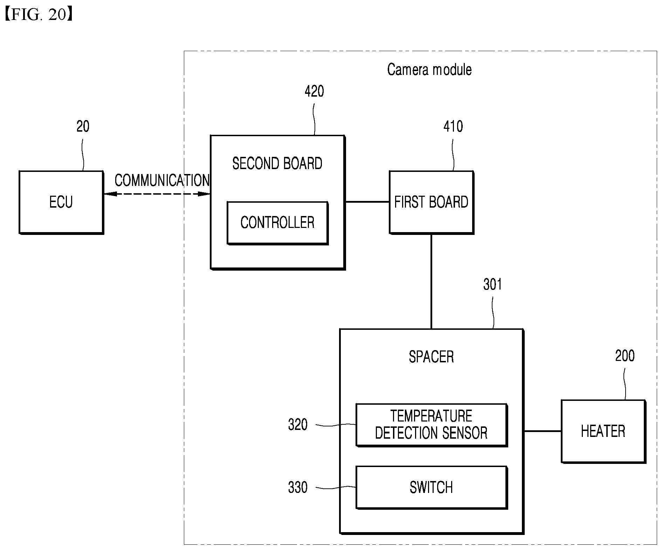

FIG 20 is a view for describing operation of the camera module according to one embodiment. The operation of the camera module according to the first embodiment will be described with reference to a structure illustrated in FIG 20.

The camera module may be electrically connected to the ECU 20 provided in a vehicle and may receive electricity from the ECU 20.

In addition, the camera module may be connected to the ECU 20 to enable wired or wireless communication and receive control commands from the ECU 20 or transmit information on images, that is, photos or videos captured by the camera module to the ECU 20.

The first board 410 may be electrically communicatively connected to the ECU 20. The first board 410 and the second board 420 may be electrically connected. The first board 410 may be electrically connected to the temperature detection sensor 320 and the switch 330 provided in the spacer 301. The temperature detection sensor 320 and the switch 330 may be electrically connected to the heater 200.

The controller provided on the second board 420 may obtain information on the temperature of the connection unit 300 provided with the spacer 301 from the temperature detection sensor 320. When the temperature detected by the temperature detection sensor 320 exceeds the set range, the controller may operate the switch 330 to stop heat generation of the heater 200.

When the temperature detected by the temperature detection sensor 320 decreases to the set range and reaches a set temperature, the controller may re-operate the switch 330 so that the heater 200 re-generates heat. By this method, the controller may control the amount of heat generated by the heater 200 to maintain the temperature of the connection unit 300 within the set range.

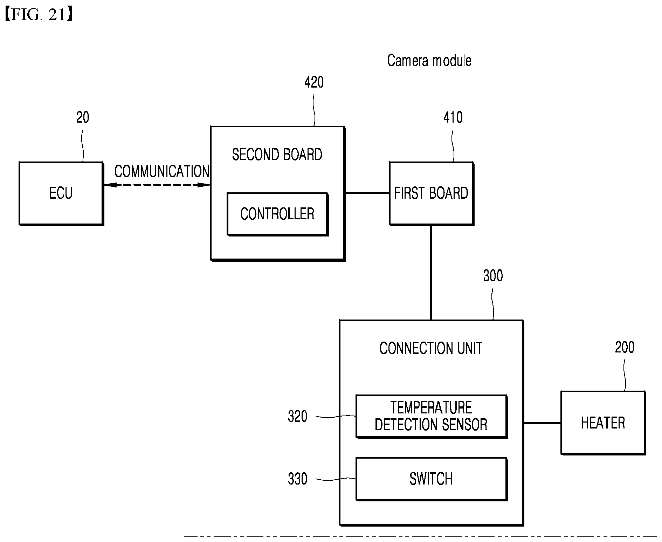

FIG 21 is a view for describing operation of the camera module according to another embodiment. The operation of the camera module according to the first embodiment will be described with reference to a structure illustrated in FIG 21. Compared to the structure illustrated in FIG 20, the structure illustrated in FIG 21 includes the temperature detection sensor 320 and the switch 330 provided in one integrated connection unit 300.

The first board 410 may be electrically communicatively connected to the ECU 20. The first board 410 and the second board 420 may be electrically connected. The first board 410 may be electrically connected to the temperature detection sensor 320 and the switch 330 provided in the connection unit 300. The temperature detection sensor 320 and the switch 330 may be electrically connected to the heater 200.

The controller provided on the second board 420 may obtain the information on the temperature of the connection unit 300 from the temperature detection sensor 320. When the temperature detected by the temperature detection sensor 320 exceeds the set range, the controller may operate the switch 330 to stop heat generation of the heater 200.

When the temperature detected by the temperature detection sensor 320 decreases to the set range and reaches a set temperature, the controller may re-operate the switch 330 so that the heater 200 re-generates heat. By this method, the controller may control the amount of heat generated by the heater 200 to maintain the temperature of the connection unit 300 within the set range.

### [Third embodiment]

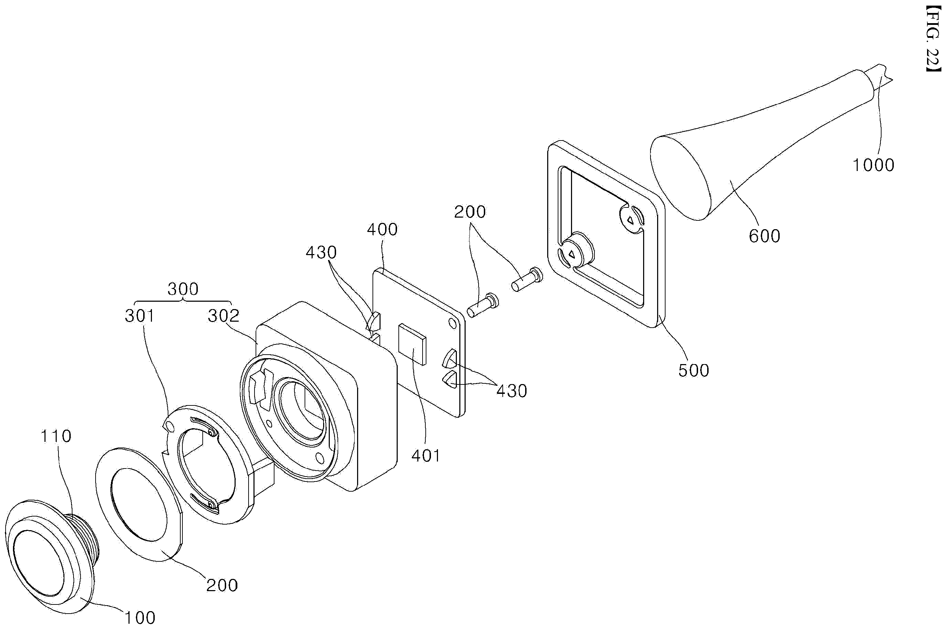

Hereinafter, a structure of a camera module according to a third embodiment will be described in detail with reference to FIG 22. In the following description, descriptions of parts overlapping the above description may be omitted.

FIG 22 is an exploded view illustrating a camera module according to still another embodiment. As illustrated in FIG 22, compared to the first embodiment and the second embodiment in which the printed circuit board 400 is divided into the first board 410 and the second board 420, in the third embodiment, one integrated printed circuit board 400 may be provided. The rest of the structure is the same as or very similar to those of the first embodiment.

The printed circuit board 400 may be electrically connected to the spacer 301 by the first connection pins 430. Since only one printed circuit board 400 is provided, the second connection pin 440 used for electrical connection between the first board 410 and the second board 420 in the first embodiment and the second embodiment may not be provided.

The printed circuit board 400 may be provided to be accommodated in the front case 302. The printed circuit board 400 may be equipped with the image sensor 401 for capturing images outside the camera module, provided with the controller for controlling the camera module, a communication device for communication with the ECU 20, or the like, and provided with a circuit for connecting these elements.

In addition, the printed circuit board 400 may be equipped with elements such as a capacitor for supplying electricity to the spacer 301 or the like and provided with a circuit for connecting these elements.

### [Fourth embodiment]

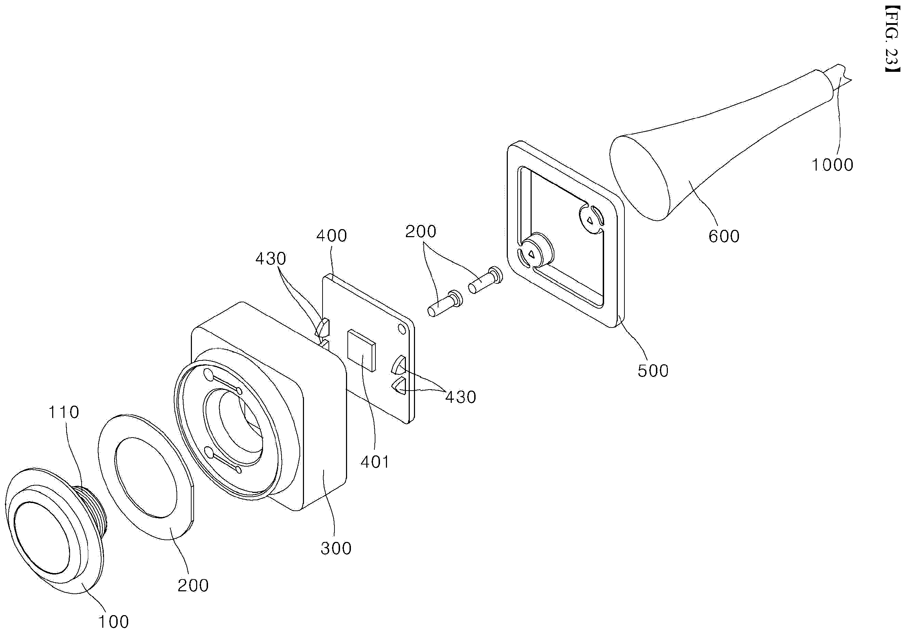

Hereinafter, a structure of a camera module according to a fourth embodiment will be described in detail with reference to FIG 23. In the following description, descriptions of parts overlapping the above description may be omitted.

FIG 23 is an exploded view illustrating a camera module according to yet another embodiment. Compared to other embodiments, the camera module according to the fourth embodiment may include one integrated connection unit 300 and one integrated printed circuit board 400.

In other words, in the fourth embodiment, the connection unit 300 may be provided in a form in which the spacer 301 and the front case 302 are integrated into one, and the printed circuit board 400 may be provided in a form in which the first board 410 and the second board 420 may be integrated into one.

As illustrated in FIG 23, compared to the first embodiment and the second embodiment in which the printed circuit board 400 is divided into the first board 410 and the second board 420, in the fourth embodiment, one integrated printed circuit board 400 may be provided. The rest of the structure is the same as or similar to those of the second embodiment. In addition, a structure related to the printed circuit board 400 is the same as or very similar to that of the third embodiment described above with reference to FIG 22.

Although the present invention has been described above with reference to exemplary drawings, the present invention is not limited by the embodiments and drawings disclosed in the specification, and it is apparent that various modifications can be made by those skilled in the art within the scope of the technical spirit of the present invention. In addition, even when the operational effects according to the configuration of the present invention have not been explicitly described in the description of the embodiments of the present invention, it goes without saying that the effects predictable by the corresponding configuration should be recognized.

## Claims

1. A camera module comprising:
a lens barrel;
a heater disposed at the rear of the lens barrel;
a connection unit on which the heater is mounted and which is coupled to the lens barrel to be in close contact with the heater and electrically connected to the heater; and
a printed circuit board which is accommodated in the connection unit and electrically connected to the heater through the connection unit, and on which an image sensor is mounted.

2. The camera module of claim 1, wherein the connection unit further includes:
a conductive wire pattern that is in contact with the heater to be electrically connected to the heater and provided in the connection unit; and
a temperature detection sensor electrically connected to the conductive wire pattern.

3. The camera module of claim 2, wherein the connection unit further includes a switch electrically connected to the conductive wire pattern and configured to allow a current to be blocked or flow in the heater and the printed circuit board.

4. The camera module of claim 3, wherein the printed circuit board includes a first connection pin mounted on a surface thereof facing the conductive wire pattern and in contact with the conductive wire pattern to electrically connect the connection unit to the printed circuit board.

5. The camera module of claim 4, wherein the connection unit includes:
a spacer of which one surface is in close contact with the heater to be electrically connected to the heater and which includes the conductive wire pattern, the temperature detection sensor, and the switch; and
a front case in which the heater and the spacer are accommodated and which is coupled to the lens so that the heater and the spacer are in close contact with each other.

6. The camera module of claim 5, wherein the temperature detection sensor and the switch are provided to be mounted on a surface facing the front case of the spacer.

7. The camera module of claim 5, wherein the spacer and the front case are made of a material to be injection-molded, and the conductive wire pattern is made of a material having durability.

8. The camera module of claim 5, wherein a guide groove is formed in a surface of the front case facing the spacer, and the spacer is formed with a guide protrusion formed to protrude toward the guide groove from a surface facing the front case and inserted into the guide groove to suppress rotation of the spacer.

9. The camera module of claim 6, wherein the front case includes a first hollow formed at a position corresponding to the image sensor and at least one insertion hole formed at a position spaced apart from the first hollow, and
the spacer includes a protruding portion formed to protrude from a surface facing the front case and inserted into the insertion hole.

10. The camera module of claim 9, wherein the spacer includes:
a via hole formed to pass through the spacer and having the conductive wire pattern provided on at least a portion of a surface of an inner wall thereof;
an elastic deformation portion formed to protrude in a circumferential direction or a diameter direction of the spacer and provided to be elastically deformed; and
a contact protrusion formed to protrude from a surface of an end portion of the elastic deformation portion facing the heater and coming into contact with the heater.

11. The camera module of claim 10, wherein the spacer has the conductive wire pattern provided on an end of the contact protrusion, and
the heater and the contact protrusion are in contact with each other so that the conductive wire pattern is electrically connected to the heater.

12. The camera module of claim 11, wherein the spacer further includes a pattern formation portion which is formed by removing a portion of an outer circumference thereof and on which a portion of the conductive wire pattern for connecting both side surfaces of the spacer is formed.

13. The camera module of claim 12, wherein the conductive wire pattern is provided on side surfaces of the pattern formation portion and the protruding portion, and
an end surface of the protruding portion is provided with a terminal pattern connected to the conductive wire pattern and in contact with the first connection pin to electrically connect the conductive wire pattern to the first connection pin.

14. The camera module of claim 3, wherein the temperature detection sensor and the switch are provided to be mounted on a surface facing the printed circuit board of the connection unit.

15. The camera module of claim 2, wherein the connection unit is made of a material to be injection-molded, and the conductive wire pattern is made of a material having durability.

16. The camera module of claim 4, wherein the connection unit includes:
a via hole formed to pass through the connection unit and having the conductive wire pattern provided on at least a portion of a surface of an inner wall thereof; and
a contact protrusion formed to protrude from a surface facing the heater and coming into contact with the heater.

17. The camera module of claim 16, wherein the connection unit has the conductive wire pattern provided on an end of the contact protrusion, and
the heater and the contact protrusion are in contact with each other so that the conductive wire pattern is electrically connected to the heater.

18. The camera module of claim 17, wherein the connection unit is provided with a terminal pattern provided on a surface facing the printed circuit board, connected to the conductive wire pattern, and in contact with the first connection pin to electrically connect the conductive wire pattern to the first connection pin.

19. The camera module of claim 1, wherein the printed circuit board includes:
a first board accommodated in the connection unit, electrically connected to the heater through the connection unit, and having a second hollow formed in a portion corresponding to the image sensor; and
a second board which is electrically connected to the first board and on which the image sensor is mounted.

20. The camera module of claim 19, wherein the first board includes a first connection pin provided on a surface facing the connection unit, and
the second board includes a second connection pin provided on a surface facing the first board and electrically connecting the first board to the second board.
